# EUROPÄISCHE PATENTSCHRIFT

(11) **EP 3 966 067 B1**
(45) Veröffentlichungstag und Bekanntmachung des Hinweises auf die Patenterteilung: **16.11.2022**
(21) Anmeldenummer: 20829834.9
(22) Anmeldetag: 14.12.2020
(51) Int. Cl.: B60L 1/00, B60L 1/02, B60L 3/00, B60L 50/71, B60L 50/72, B60L 50/75, B60L 58/30, B60L 58/40

(54) **VERSORGUNGSEINRICHTUNG, BRENNSTOFFZELLENFAHRZEUG UND VERFAHREN ZUR SPANNUNGSBEGRENZUNG BEI EINER VERSORGUNGSEINRICHTUNG**
SUPPLY DEVICE, FUEL CELL VEHICLE, AND METHOD FOR LIMITING VOLTAGE IN A SUPPLY DEVICE
DISPOSITIF D'ALIMENTATION, VÉHICULE À PILE À COMBUSTIBLE ET PROCÉDÉ DE LIMITATION DE TENSION DANS UN DISPOSITIF D'ALIMENTATION

(30) Priorität: 23.01.2020 DE 102020101527
(43) Veröffentlichungstag der Anmeldung: 16.03.2022
(73) Patentinhaber: Audi AG, 85045 Ingolstadt (DE)
(72) Erfinder: RUF, Markus, 73550 Waldstetten (DE); MÜLLER, Kai, 74626 Bretzfeld (DE)
(74) Vertreter: Hentrich Patent- & Rechtsanwälte PartG mbB
(86) Internationale Anmeldenummer: PCT/EP2020/085889
(87) Internationale Veröffentlichungsnummer: WO 2021/148197

(56) Entgegenhaltungen:
- DE-A1- 10 010 985
- DE-A1-102013 012 151

## Beschreibung

Die Erfindung betrifft eine Versorgungseinrichtung für die elektrische Versorgung mindestens eines Verbrauchers, mit einem Primärstromnetz, in dem eine erste Brennstoffzelleneinrichtung mit einer ersten Leistungsfähigkeit vorliegt, mit einem Spannungswandler, der das Primärstromnetz mit einem eine Batterie umfassenden Sekundärstromnetz verbindet, und mit mindestens einer Messeinrichtung zur Erfassung eines Isolationswiderstandes der Versorgungseinrichtung, insbesondere des Primärstromnetzes und/oder des Sekundärstromnetzes. Die Erfindung betrifft außerdem ein Brennstoffzellenfahrzeug mit einer Versorgungseinrichtung sowie ein Verfahren zur Spannungsbegrenzung einer Versorgungseinrichtung bei der elektrischen Versorgung eines Verbrauchers.

Derartige Versorgungseinrichtungen werden typischweise in Brennstoffzellenfahrzeugen eingesetzt, wobei für derartig elektrisch angetriebene Fahrzeuge der Isolationswiderstand typischerweise 100 Ohm / Volt in Bezug zur höchsten auftretenden Spannung zu betragen hat, um einen Menschen vor einem für ihn gefährlichen Stromschlag zu schützen.

Eine eingangs erwähnte Versorgungseinrichtung gemäß dem Oberbegriff des Anspruchs 1 ist in der DE 10 2016 219 984 A1 gezeigt. Hierbei wird mittels mehrerer Messeinrichtungen der Isolationswiderstand des hybrid aus einer Brennstoffzelleneinrichtung und einer Batterie gebildeten Brennstoffzellenfahrzeugs ermittelt. In Abhängigkeit des ermittelten Werts des Isolationswiderstands wird das Brennstoffzellenfahrzeug zum Schutz vor einem gefährlichen Stromschlag in einen Notfahrmodus oder sogar in einen Leerlauf-Stopp-Modus versetzt.

In der US 2008 / 0 107 933 A1 ist ein Brennstoffzellensystem beschrieben, das in Abhängigkeit der gestellten Lastanforderung eine unterschiedliche Anzahl an Brennstoffzellenstapeln zur Leistungsbereitstellung aktiv oder inaktiv stellt.

In der US 2017 / 0 162 924 A1 ist ein Brennstoffzellensystem beschrieben, welches die vom Brennstoffzellenstapel gelieferte Spannung überwacht und bei Überschreiten einer Grenzspannung des gesamten Systems in einen Notbetrieb übergeht.

In der CN 109 606 203 A ist ein Verfahren zum Betreiben eines mit einer Batterie und einer Brennstoffzelleneinrichtung gebildeten Systems beschrieben, das bei kritischen Ereignissen einen Notstopp bewirkt.

Die DE 10 2013 012 151 A1 beschreibt eine Versorgungseinrichtung mit Brennstoffzellen, wobei jeder Brennstoffzelle ein eigener Spannungswandler zugewiesen ist, um die Gleichspannung der Brennstoffzellen auf eine im Sekundärnetz des Fahrzeugs vorliegende Spannungslage zu wandeln, in welchem zudem eine Batterie und der Elektromotor vorliegen, wobei letzterer über einen Umrichter an das Sekundärnetz gekoppelt ist.

In der DE 100 10 985 A1 wird ein System aus einer Parallelschaltung von einer Mehrzahl in Reihe geschalteter Brennstoffzellenstapel beschrieben. Hierbei wird selektiv eine Überbrückung der einzelnen Brennstoffzellenstapel vorgenommen, um die gewünschte Leistungsfähigkeit einzustellen.

Es ist die Aufgabe der vorliegenden Erfindung eine Versorgungseinrichtung, ein Brennstoffzellenfahrzeug und ein Verfahren zur Spannungsbegrenzung anzugeben, die eine erhöhte Sicherheit bieten.

Diese Aufgabe wird gelöst durch eine Versorgungseinrichtung mit den Merkmalen des Anspruchs 1, durch ein Brennstoffzellenfahrzeug mit den Merkmalen des Anspruchs 5 und durch ein Verfahren mit den Merkmalen des Anspruchs 6. Vorteilhafte Ausgestaltungen mit zweckmäßigen Weiterbildungen der Erfindung sind in den abhängigen Ansprüchen angegeben.

Die erfindungsgemäße Versorgungseinrichtung zeichnet sich insbesondere dadurch aus, dass der ersten Brennstoffzelleneinrichtung im Primärstromnetz eine zweite Brennstoffzelleneinrichtung mit einer von der ersten Leistungsfähigkeit abweichenden zweiten Leistungsfähigkeit in Reihe geschaltet ist, dass jeder der Brennstoffzelleneinrichtungen jeweils eine einen Schalter umfassende Überbrückungsschaltung parallel geschaltet ist, und dass die Schalter der Überbrückungsschaltungen in Abhängigkeit des erfassten Isolationswiderstands schaltbar sind.

Wenn zwei Brennstoffzelleneinrichtungen eingesetzt werden, bei denen sich die Leistungsfähigkeit unterscheidet, lässt sich gewährleisten, dass aufgrund des vorliegenden Isolationswiderstands die Spannung auf einen für einen Menschen ungefährliches Niveau gesenkt wird, da nur noch diejenige der Brennstoffzelleneinrichtung Leistung bereitstellt, die eine niedrige Spannung besitzt. Das Dynamikverhalten der noch aktiven Brennstoffzelleneinrichtung, also die situationsangepasste Einstellung des Lastpunkts, kann in diesem Notbetrieb eingeschränkt werden. Ein die Versorgungseinrichtung verwendendes Brennstoffzellenfahrzeug kann noch immer in einem Notfahrmodus ("limp home") mit verrringerter Leistung weiterbetrieben oder weitergefahren werden, wobei es nicht notwendig ist, das Brennstoffzellenfahrzeug in einen Stopp-Modus zu versetzen und an einer Weiterfahrt zu hindern.

Um die Spannung der Versorgungseinrichtung, insbesondere ihre Ausgangsspannung, auf einen für einen Menschen ungefährlichen Wert zu begrenzen und damit den Isolationswiderstand auf oder über einen vorgegebenen Widerstandswert anzuheben, ist es von Vorteil, dass der Batterie im Sekundärstromnetz ebenfalls eine Überbrückungsschaltung parallel geschaltet ist, welche einen in Abhängikeit des erfassten Isolationswiderstands schaltbaren Schalter umfasst.

Es ist in einer vorteilhaften Ausgestaltung möglich, dass der Spannungswandler zur Einstellung der Spannungslage der ersten Brennstoffzelleneinrichtung, der Spannungslage der zweiten Brennstoffzelleneinrichtung sowie der Spannungslage der Batterie als ein Triport-Wandler gebildet ist. Somit kann der Triport-Wandler gewährleisten, dass der Isolationswiderstand nicht unter einen vorgegebenen Widerstandswert fällt, was zu einem für einen Menschen gefährlichen Stromschlag führen könnte. Hierfür wird zunächst mittels der Messeinrichtung der Isolationswiderstand ermittelt, aus welchem dann die für die Versorgungseinrichtung maximal mögliche, für einen Menschen ungefährliche Spannung berechnet wird. Die Einzelspannungen der Brennstoffzelleneinrichtungen und der Batterie werden dann derart eingestellt und ggfs. aufeinander abgestimmt, dass dieser Maximalspannungswert nicht überschritten wird.

Um eine für unterschiedliche Anwendungen nutzbare Leistungsskalierung bereitstellen zu können, ist es zudem von Vorteil, wenn im Primärstromnetz mindestens eine weitere Brennstoffzelleneinrichtung mit einer ihr zugeordneten, einen Schalter umfassenden Überbrückungsschaltung vorhanden und mit den übrigen Brennstoffzelleneinrichtungen in Reihe geschaltet ist.

Die in Verbindung mit der erfindungsgemäßen Versorungseinrichtung erläuterten Vorteile, technischen Wirkungen und vorteilhaften Ausgestaltungen gelten in gleichem Maße für das erfindungsgemäße Brennstoffzellenfahrzeug. Dieses zeichnet sich dadurch aus, dass im Falle eines zu geringen Isolationswiderstands eine Weiterfahrt mit verrigerter Leistung möglich bleibt und ein Notstopp ("Emergency Shutdown") vermieden wird.

Das erfindungsgemäße Verfahren zur Spannungsbegrenzung einer vorstehend Versorgungseinrichtung bei der elektrischen Versorgung eines Verbrauchers umfasst insbesondere die folgenden Schritte:
A. Erfassen des Isolationswiderstandes im Primärstromnetz und/oder im Sekundärstromnetz mittels der Messeinrichtung,
B. Prüfen, ob der Isolationswiderstand einen vorgegebenen Widerstandswert unterschritten hat, und
C. im Fall eines unterschrittenen Widerstandswerts, Ansteuerung eines oder mehrerer Schalter der Überbrückungsschaltungen derart, dass mindestens eine der Brennstoffzelleneinrichtungen überbrückt und somit, zumindest teilweise, vorzugsweise vollständig inaktiv gestellt wird, und dass eine andere der Brennstoffzelleneinrichtungen unüberbrückt ist und somit zur Bereitstellung einer Spannung aktiv gestellt wird.

Es ist bei diesem Verfahren so, dass die erste Brennstoffzelleneinrichtung eine erste Leistungsfähigkeit aufweist, und dass die zweite Brennstoffzelleinrichtung eine von der ersten Leistungsfähigkeit abweichende zweite Leistungsfähigkeit aufweist, und dass im Fall eines unterschrittenen Widerstandswerts diejenige Brennstoffzelleneinrichtung überbrückt wird, die die höhere Leistungsfähigkeit vorweist.

Auf diese Weise ist eine Notversorgung der Verbraucher mit verringerter Leistung gewährleistet, so dass ein Notstopp der Verbraucher vermieden ist.

Es ist von Vorteil, wenn im Falle eines unterschrittenen Widerstandswerts der Ladezustand (SOC) der Batterie herabgesetzt wird, da auf diese Weise die Spannung der Versorungseinrichtung insgesamt herabgesetzt wird.

Sollte das bloße Herabsetzen der Spannungslage der Batterie nicht ausreichen, um den Isolationswiderstand auf einen vorgegebenen Widerstandswert anzuheben, so ist die Möglichkeit gegeben, dass der Batterie im Sekundärstromnetz ebenfalls eine Überbrückungsschaltung parallel geschaltet ist, welche einen in Abhängigkeit des erfassten Isolationswiderstands schaltbaren Schalter umfasst, und dass die Batterie im Falle eines unterschrittenen Widerstandwerts ebenfalls überbrückt und somit inaktiv gestellt wird.

Um die Betriebssicherheit der Versorgungseinrichtung zu erhöhen, ist es zudem von Vorteil, wenn der Spannungswandler als ein Triport-Wandler gebildet ist, wenn der Triport-Wandler im Falle eines unterschrittenen Widerstandwerts die Spannungslage der ersten Brennstoffzelleneinrichtung, die Spannungslage der zweiten Brennstoffzelleneinrichtung und/oder die Spannungslage der Batterie herabsetzt. Somit kann dieser Triport-Wandler also in Abhängigkeit des vorliegenden Isolationswiderstands und der sich daraus ergebenden Maximalspannung der Versorgungseinrichtung die Spannungslagen aller Konstituenten auf einen für einen Menschen ungefährlichen Wert einstellen.

Weitere Vorteile, Merkmale und Einzelheiten der Erfindung ergeben sich aus den Ansprüchen, der nachfolgenden Beschreibung der bevorzugten Ausführungsform und sowie anhand der Zeichnung. Dabei zeigt:

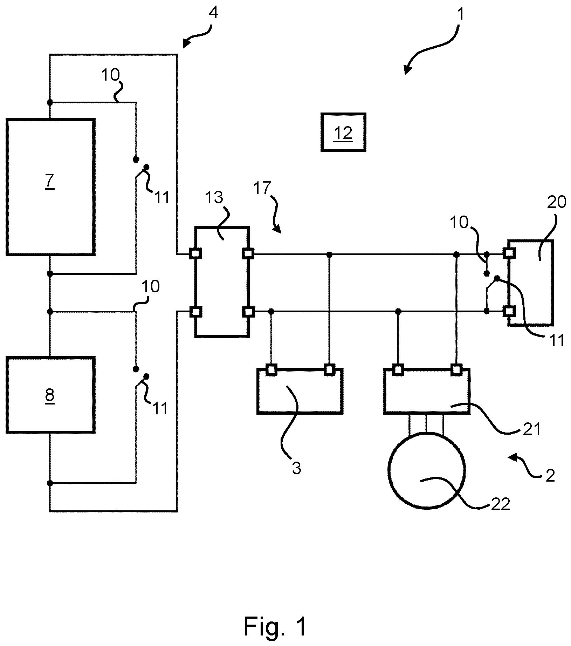

- Figur 1: eine schematische Darstellung einer Versorgungseinrichtung für die elektrische Versorgung mindestens eines Verbrauchers in Form einer Antriebseinrichtung mit Antriebsaggregat zum Antreiben eines Kraftfahrzeugs.

In Figur 1 ist eine schematische Darstellung einer Versorgungseinrichtung 1 für die elektrische Versorgung eines ersten Verbrauchers 2 und eines zweiten Verbrauchers 3 gezeigt. Die vorliegende Versorgungseinrichtung 1 kann vorzugsweise auch weitere nicht näher dargestellte Verbraucher mit elektrischer Energie versorgen.

Die Versorgungseinrichtung 1 umfasst ein Primärstromnetz 4, in dem eine erste Brennstoffzelleneinrichtung 7 und eine zweite Brennstoffzelleneinrichtung 8 vorliegen, welche miteinander in Reihe geschaltet sind. Außerdem weist die Versorgungseinrichtung 1 ein Sekundärstromnetz 17 auf, in dem eine Batterie 20 vorliegt. Die Batterie 20 ist ausgelegt, die Verbraucher 2, 3 zu bestromen. Das Primärstromnetz 4 ist eingangsseitig an einen Spannungswandler 13 angeschlossen, wobei das Sekundärstromnetz 17 vorliegend ausgangsseitig an den Spannungswandler 13 angeschlossen ist, so dass der Spannungswandler 13 das Primärstromnetz 4 mit dem Sekundärstromnetz 17 verbindet.

Der Verbraucher 2 umfasst ein Antriebsaggregat 22, welches in Form einer elektrischen Maschine vorliegt. Diese elektrische Maschine ist typischerweise mittels eines Drei-Phasen-Wechselstroms betreibbar und ist vorzugsweise als Fahrmotor für ein Kraftfahrzeug gebildet. Da das Primärstromnetz 4 und auch das Sekundärstromnetz 17 eine Hochspannung und einen Gleichstrom liefern, ist dem Verbraucher 2 zusätzlich der Wechselrichter 21 zugeordnet, der den Gleichstrom in den Drei-Phasen-Wechselstrom wandelt. In einer Weiterbildung des Verbrauchers 2 kann das Antriebsaggregat 22 auch als Generator eingesetzt werden, so dass beispielsweise beim Bremsvorgang durch das Antriebsaggregat 22 erzeugte Energie der Batterie 20 über den Wechselrichter 21 wieder zugeführt werden kann.

Der Verbraucher 3 kann ebenfalls an das aus dem Primärstromnetz 4 und Sekundärstromnetz 17 gebildete Bordnetz angeschlossen sein. Als Verbraucher 3 kommen beispielsweise Nebenaggregate der Brennstoffzelleneinrichtung 7, ein Ladegerät, ein 12V-Gleichstrom-Gleichstromwandler, ein Hochspannungs-Heizer, ein elektrischer Klimakompressor oder dergleichen in Betracht.

Die vorliegende Versorgungseinrichtung 1 zeichnet sich durch mehrere Überbrückungsschaltungen 10 aus, die jeweils einen Schalter 11 umfassen. Jeder Brennstoffzelleneinrichtung 7, 8 im Primärstromnetz 4 ist dabei eine eigene Überbrückungsschaltung 10 parallel geschaltet um wahlweise, bei geschlossenem Schalter 11 die Brennstoffzelleneinrichtung 7, 8 elektrisch zu überbrücken und damit inaktiv zu stellen, oder bei geöffnetem Schalter 11 die betreffende Brennstoffzelleneinrichtung 7, 8 aktiv zu stellen, damit diese eine elektrische Spannung bereitstellt. Im gezeigten Beispiel ist auch der Batterie 20 eine Überbrückungsschaltung 10 mit einem Schalter 11 parallel geschaltet, mit welcher die Batterie 20 bei geschlossenem Schalter 11 elektrisch überbrückt und damit inaktiv gestellt ist, und mit welcher bei geöffnetem Schalter 11 die Batterie 20 aktiv gestellt ist, damit diese eine elektrische Spannung bereitstellen oder aufnehmen kann.

Die Ansteuerung der Schalter 11 erfolgt beispielsweise mittels des Spannungswandlers 13, der beispielsweise als Triport-Wandler gebildet ist, damit er die Spannungslage der ersten Brennstoffzelleneinrichtung 7, der zweiten Brennstoffzelleneinrichtung 8 sowie der Batterie 20 einstellen kann. Es kann aber auch ein anderes - vom Spannungswandler 13 getrenntes - Steuergerät zur Ansteuerung der Überbrückungsschaltungen 10 vorhanden und eingesetzt sein.

Die Versorgungseinrichtung 1 umfasst eine Messeinrichtung 12 zur Erfassung eines Isolationswiderstandes des Primärstromnetzes 4 und/oder des Sekundärstromnetzes 17. Die gezeigte Messeinrichtung 12 erfasst vorzugsweise den Isolationswiderstand der gesamten Versorgungseinrichtung 1, mithin also des gesamten Systems. Es können mehrere Messeinrichtungen 12 vorhanden sein, so dass vorzugsweise eine erste Messeinrichtung 12 den Isolationswiderstand des Primärstromnetzes 4 und eine zweite Messeinrichtung den Isolationswiderstand des Sekundärstromnetzes 17 erfasst.

Im Betrieb der Versorgungseinrichtung 1 wird gewährleistet, dass ihr Isolationswiderstand nicht unter einen für einen Menschen gefährlichen Wert sinkt. Aus diesem Grund wird der Isolationswiderstand im Primärstromnetz 4 und/oder im Sekundärstromnetz 17 mittels der Messeinrichtung 12 getaktet oder kontinuierlich erfasst. Anschließend wird geprüft, ob der Isolationswiderstand einen vorgegebenen Widerstandswert unterschritten hat, wobei im Fall eines unterschrittenen Widerstandswerts einer oder mehrere der Schalter 11 der Überbrückungsschaltungen 10 derart angesteuert und geschaltet werden, dass diejenige Brennstoffzelleneinrichtung 7, 8 mit einer größeren Leistungsfähigkeit überbrückt und somit vorzugsweise vollständig inaktiv gestellt wird, und diejenige Brennstoffzelleneinrichtung 7, 8 mit einer geringeren Leistungsfähigkeit unüberbrückt ist und somit zur Bereitstellung einer Spannung aktiv gestellt wird.

Vorzugsweise wird im Falle eines unterschrittenen Widerstandswerts außerdem der Ladezustand (SOC) der Batterie 20 herabgesetzt. Genügt das Herabsetzen nicht, um zum gewünschten Isolationswert des Systems zu gelangen, so kann die der Batterie 20 zugewiesene Überbrückungsschaltung 10 genutzt werden. Dann wird nämlich die Batterie 20 im Falle eines trotz Herabsetzen des SOC noch immer unterschrittenen Widerstandwerts ebenfalls überbrückt und somit inaktiv gestellt.

Durch die entsprechende Stellung der Schalter 11 im Primärstromnetz 4 und/oder der Schalter 11 im Sekundärstromnetz 17 lässt sich gewährleisten, dass der Isolationswiderstand auf einen für einen Menschen ungefährlichen Wert erhöht wird und ein die Versorgungseinrichtung verwendendes Brennstoffzellenfahrzeug noch immer in einem Notfahrmodus ("limp home"-Modus) betrieben werden kann. Eine Weiterfahrt ist somit möglich. Es ist auf diese Weise also nicht notwendig, das Brennstoffzellenfahrzeug in einen Stopp-Modus zu versetzen und an einer Weiterfahrt oder einem Weiterbetrieb zu hindern.

Das vorstehend beschriebene Verfahren und die vorstehend beschriebene Versorgungseinrichtung 1 bieten eine hohe Betriebssicherheit bei gleichzeitig kompakter Bauweise aller beteiligten Konstituenten. Entsprechendes gilt also auch für eine Antriebseinrichtung eines Brennstoffzellenfahrzeugs, die mit einer solchen Versorgungseinrichtung 1 mit elektrischer Energie versorgt wird.

### BEZUGSZEICHENLISTE:

- 1: Versorgungseinrichtung
- 2: Verbraucher
- 3: (zweiter) Verbraucher
- 4: Primärstromnetz
- 7: erste Brennstoffzelleneinrichtung
- 8: zweite Brennstoffzelleneinrichtung
- 10: Überbrückungsschaltung
- 11: Schalter
- 12: Messeinrichtung
- 13: Spannungswandler
- 17: Sekundärstromnetz
- 20: Batterie
- 21: Wechselrichter
- 22: Antriebsaggregat

## Patentansprüche

1. Versorgungseinrichtung (1) für die elektrische Versorgung mindestens eines Verbrauchers (2,3),
mit einem Primärstromnetz (4), in dem eine erste Brennstoffzelleneinrichtung (7) mit einer ersten Leistungsfähigkeit vorliegt,
mit einem Spannungswandler (13), der das Primärstromnetz (4) mit einem eine Batterie (20) umfassenden Sekundärstromnetz (17) verbindet, und mit einer Messeinrichtung (12) zur Erfassung eines Isolationswiderstandes des Primärstromnetzes (4) und/oder des Sekundärstromnetzes (17),
**dadurch gekennzeichnet, dass** der ersten Brennstoffzelleneinrichtung (7) im Primärstromnetz (4) eine zweite Brennstoffzelleneinrichtung (8) mit einer von der ersten Leistungsfähigkeit abweichenden zweiten Leistungsfähigkeit in Reihe geschaltet ist,
dass jeder der Brennstoffzelleneinrichtungen (7, 8) jeweils eine einen Schalter (11) umfassende Überbrückungsschaltung (10) parallel geschaltet ist,
und dass die Schalter (11) der Überbrückungsschaltungen (10) in Abhängigkeit des erfassten Isolationswiderstands schaltbar sind.

2. Versorgungseinrichtung (1) nach Anspruch 1, **dadurch gekennzeichnet, dass** der Batterie (20) im Sekundärstromnetz (17) ebenfalls eine Überbrückungsschaltung (10) parallel geschaltet ist, welche einen in Abhängigkeit des erfassten Isolationswiderstands schaltbaren Schalter (11) umfasst.

3. Versorgungseinrichtung (1) nach Anspruch 1 oder 2, **dadurch gekennzeichnet, dass** der Spannungswandler (13) zur Einstellung der Spannungslage der ersten Brennstoffzelleneinrichtung (7), der Spannungslage der zweiten Brennstoffzelleneinrichtung (8) sowie der Spannungslage der Batterie (20) als ein Triport-Wandler gebildet ist.

4. Versorgungseinrichtung (1) nach einem der Ansprüche 1 bis 3, **dadurch gekennzeichnet, dass** im Primärstromnetz (4) mindestens eine weitere Brennstoffzelleneinrichtung mit einer ihr zugeordneten, einen Schalter (11) umfassenden Überbrückungsschaltung (10) vorhanden und mit den übrigen Brennstoffzelleneinrichtungen (7, 8) in Reihe geschaltet ist.

5. Brennstoffzellenfahrzeug mit einer Versorgungseinrichtung (1) nach einem der Ansprüche 1 bis 4.

6. Verfahren zur Spannungsbegrenzung einer Versorgungseinrichtung (1) bei der elektrischen Versorgung eines Verbrauchers (2, 3) nach einem der Ansprüche 1 bis 4,
die ein Primärstromnetz (4) aufweist, in dem eine erste Brennstoffzelleneinrichtung (7) und eine zweite Brennstoffzelleneinrichtung (8) vorliegen, wobei die Brennstoffzelleneinrichtungen (7, 8) im Primärstromnetz (7) miteinander in Reihe geschaltet sind, und wobei den Brennstoffzelleneinrichtungen (7, 8) im Primärstromnetz (7) jeweils eine einen Schalter (11) umfassende Überbrückungsschaltung (10) parallel geschaltet ist,
die einen Spannungswandler (13) umfasst, der das Primärstromnetz (4) mit einem eine Batterie (20) umfassenden Sekundärstromnetz (17) verbindet,
und die eine Messeinrichtung (12) zur Erfassung eines Isolationswiderstandes des Primärstromnetzes (4) und/oder des Sekundärstromnetzes (17) aufweist,
umfassend die folgenden Schritte:
A. Erfassen des Isolationswiderstandes im Primärstromnetz (4) und/oder im Sekundärstromnetz (17) mittels der Messeinrichtung (12),
B. Prüfen, ob der Isolationswiderstand einen vorgegebenen Widerstandswert unterschritten hat, und
C. im Fall eines unterschrittenen Widerstandswerts, Ansteuerung eines oder mehrerer Schalter (11) der Überbrückungsschaltungen (10) derart, dass mindestens eine der
Brennstoffzelleneinrichtungen (7, 8) überbrückt und somit, zumindest teilweise, vorzugsweise vollständig inaktiv gestellt wird, und dass eine andere der Brennstoffzelleneinrichtungen (7, 8) unüberbrückt ist und somit zur Bereitstellung einer Spannung aktiv gestellt wird.

7. Verfahren nach Anspruch 6, **dadurch gekennzeichnet, dass** sich die erste Leistungsfähigkeit von der zweiten Leistungsfähigkeit unterscheidet, und dass im Falle eines unterschrittenen Widerstandswerts diejenige Brennstoffzelleneinrichtung (7, 8) mit der höheren Leistungsfähigkeit überbrückt wird.

8. Verfahren nach Anspruch 6 oder 7, **dadurch gekennzeichnet, dass** im Falle eines unterschrittenen Widerstandswerts der Ladezustand (SOC) der Batterie (20) herabgesetzt wird.

9. Verfahren nach Anspruch 8, **dadurch gekennzeichnet, dass** der Batterie (20) im Sekundärstromnetz (17) ebenfalls eine Überbrückungs-schaltung (10) parallel geschaltet ist, welche einen in Abhängikeit des erfassten Isolationswiderstands schaltbaren Schalter (11) umfasst, und dass die Batterie (20) im Falle eines unterschrittenen Widerstandwerts ebenfalls überbrückt und somit inaktiv gestellt wird.

10. Verfahren nach einem der Ansprüche 6 bis 9, **dadurch gekennzeichnet, dass** der Spannungswandler (13) als ein Triport-Wandler gebildet ist, dass der Triport-Wandler und im Falle eines unterschrittenen Widerstandwerts die Spannungslage der ersten Brennstoffzelleneinrichtung (7), die Spannungslage der zweiten Brennstoffzelleneinrichtung (8) und/oder die Spannungslage der Batterie (20) herabsetzt.

## Claims

1. A supply device (1) for the electrical supply of at least one load (2, 3),
having a primary power grid (4), in which a first fuel cell device (7) having a first performance capability is present,
having a voltage converter (13), which connects the primary power grid (4) to a secondary power grid (17) comprising a battery (20), and
having a measuring device (12) for detecting an insulation resistance of the primary power grid (4) and/or of the secondary power grid (17),
**characterized in that** a second fuel cell device (8) having a second performance capability different than the first performance capability is connected in series to the first fuel cell device (7) in the primary power grid (4),
**in that** a bypass circuit (10) comprising a switch (11) is connected in each case in parallel to each of the fuel cell devices (7, 8),
and **in that** the switches (11) of the bypass circuits (10) can be switched depending on the insulation resistance detected.

2. The supply device (1) according to claim 1, **characterized in that** the battery (20) in the secondary power grid (17) is likewise connected in parallel with a bridging circuit (10), which comprises a switch (11) that can be switched in dependence on the sensed insulation resistance.

3. The supply device (1) according to claim 1 or 2, **characterized in that** the voltage converter (13) for setting the voltage position of the first fuel cell device (7), the voltage position of the second fuel cell device (8) and the voltage position of the battery (20) is formed as a triport converter.

4. The supply device (1) according to any of claims 1 to 3, **characterized in that** at least one further fuel cell device with a bypass circuit (10) assigned to it and comprising a switch (11) is present in the primary power grid (4) and is connected in series with the remaining fuel cell devices (7, 8).

5. A fuel cell vehicle having a supply device (1) according to any of claims 1 to 4.

6. A method for limiting the output voltage of a supply device (1) providing electrical energy to a load (2, 3) according to any of claims 1 to 4,
which has a primary power grid (4) in which a first fuel cell device (7) and a second fuel cell device (8) are present,
wherein the fuel cell devices (7, 8) are connected in series with one another in the primary power grid (7),
and wherein a bypass circuit (10) comprising a switch (11) is connected in parallel to the fuel cell devices (7, 8) in the primary power grid (7) in each case, which bypass circuit comprises a voltage converter (13) which connects the primary power grid (4) to a secondary power grid (17) comprising a battery (20), and which has a measuring device (12) for detecting an insulation resistance of the primary power grid (4) and/or of the secondary power grid (17), comprising the following steps:
A. Detecting the insulation resistance in the primary power grid (4) and/or in the secondary power grid (17) by means of the measuring device (12),
B. testing whether the insulation resistance has fallen below a predetermined resistance value, and
C. in the case of an undershot resistance value, actuation of one or more switches (11) of the bypass circuits (10) in such a way that at least one of the fuel cell devices (7, 8) are bypassed and therefore, at least partially, preferably completely inactive, while another of the fuel cell devices (7, 8) is not being bridged and is thus activated to provide an output voltage.

7. The method according to claim 6, **characterized in that** the first performance is inferior to the second performance, and **in that**, in the case of a resistance value which is undershot, the fuel cell device (7, 8) with the higher performance is bypassed.

8. The method according to claim 6 or 7, **characterized in that** in the case of an undershot resistance value, the state of charge (SOC) of the battery (20) is reduced.

9. The method according to claim 8, **characterized in that** a bypass circuit (10) is likewise connected in parallel to the battery (20) in the secondary power grid (17), said bypass circuit comprising a switch (11) which can be switched in dependence on the sensed insulation resistance,
and **in that** the battery (20) is likewise bypassed and therefore rendered inactive in the event of a resistance value which is not reached.

10. The method according to any of claims 6 to 9, **characterized in that** the voltage converter (13) is formed as a triport converter, **in that** the triport converter reduces the voltage level of the first fuel cell device (7), the voltage level of the second fuel cell device (8) and/or the voltage level of the battery (20) in the event of an undershot resistance value.

## Revendications

1. Dispositif d'alimentation (1) pour fournir de l'électricité à au moins un consommateur (2, 3),
comprenant un réseau électrique primaire (4) dans lequel se trouve un premier dispositif de pile à combustible (7) présentant une première performance,
un convertisseur de tension (13) qui relie le réseau électrique primaire (4) à un réseau électrique secondaire (17) comprenant une batterie (20), et un dispositif de mesure (12) pour détecter une résistance d'isolation du réseau électrique primaire (4) et/ou du réseau électrique secondaire (17),
**caractérisé en ce que** le premier dispositif à pile à combustible (7) dans le réseau électrique primaire (4) est connecté en série à un second dispositif de pile à combustible (8) présentant une seconde performance qui diffère de la première performance,
**en ce que** chacun des dispositifs de pile à combustible (7, 8) est connecté en parallèle à un circuit de dérivation (10) comprenant un commutateur (11),
et **en ce que** les commutateurs (11) des circuits de dérivation (10) peuvent être commutés en fonction de la résistance d'isolation détectée.

2. Dispositif d'alimentation (1) selon la revendication 1, **caractérisé en ce que** la batterie (20) dans le réseau électrique secondaire (17) est également connectée en parallèle à un circuit de dérivation (10) qui présente un commutateur (11) qui peut être commuté en fonction de la résistance d'isolation détectée.

3. Dispositif d'alimentation (1) selon la revendication 1 ou 2, **caractérisé en ce que** le convertisseur de tension (13), pour régler le niveau de tension du premier dispositif de pile à combustible (7), le niveau de tension du second dispositif de pile à combustible (8) et le niveau de tension de la batterie (20), est formé sous la forme d'un convertisseur triport.

4. Dispositif d'alimentation (1) selon l'une quelconque des revendications 1 à 3, **caractérisé en ce que** dans le réseau électrique primaire (4) est disponible au moins un dispositif de pile à combustible supplémentaire avec un circuit de dérivation (10) comprenant un commutateur (11) associé à celui-ci, et connecté en série aux autres dispositifs de pile à combustible (7, 8).

5. Véhicule à pile à combustible comprenant un dispositif d'alimentation (1) selon l'une quelconque des revendications 1 à 4.

6. Procédé de limitation de tension d'un dispositif d'alimentation (1) lors de l'alimentation électrique d'un consommateur (2, 3) selon l'une quelconque des revendications 1 à 4,
qui présente un réseau électrique primaire (4) dans lequel se trouvent un premier dispositif de pile à combustible (7) et un second dispositif de pile à combustible (8), dans lequel les dispositifs de pile à combustible (7, 8) sont connectés l'un à l'autre en série dans le réseau électrique primaire (7), et dans lequel dans le réseau électrique primaire (7), un circuit de dérivation (10) comprenant un commutateur (11) est connecté en parallèle aux dispositifs de pile à combustible (7, 8),
qui comprend un convertisseur de tension (13), qui relie le réseau électrique primaire (4) à un réseau électrique secondaire (17) comprenant une batterie (20),
et qui présente un dispositif de mesure (12) pour détecter une résistance d'isolation du réseau électrique primaire (4) et/ou du réseau électrique secondaire (17),
comprenant les étapes suivantes consistant à :
A. détecter la résistance d'isolation dans le réseau électrique primaire (4) et/ou dans le réseau électrique secondaire (17) à l'aide du dispositif de mesure (12),
B. vérifier si la résistance d'isolation est inférieure à une valeur de résistance prédéfinie, et
C. dans le cas où la valeur de résistance est inférieure, commander un ou plusieurs commutateurs (11) des circuits de dérivation (10) de manière à ce qu'au moins un des dispositifs de pile à combustible (7, 8) soit contourné et donc au moins partiellement, de préférence complètement désactivé, et à ce qu'un autre des dispositifs de pile à combustible (7, 8) ne soit pas contourné et soit ainsi rendu actif pour fournir une tension.

7. Procédé selon la revendication 6, **caractérisé en ce que** la première performance diffère de la seconde performance et **en ce que** dans le cas où la valeur de résistance est inférieure, le dispositif de pile de combustible (7, 8) avec la performance plus élevée est contourné.

8. Procédé selon la revendication 6 ou 7, **caractérisé en ce que** l'état de charge (SOC) de la batterie (20) est réduit dans le cas où la valeur de résistance est inférieure.

9. Procédé selon la revendication 8, **caractérisé en ce que** la batterie (20) du réseau électrique secondaire (17) est également connectée en parallèle à un circuit de dérivation (10) qui comprend un commutateur (11) commutable en fonction de la résistance d'isolation détectée, et **en ce que** la batterie (20) est également contournée dans le cas d'une valeur de résistance inférieure et est ainsi mise à l'état inactif.

10. Procédé selon l'une quelconque des revendications 6 à 9, **caractérisé en ce que** le convertisseur de tension (13) est réalisé sous la forme d'un convertisseur triport, **en ce que** le convertisseur triport et, dans le cas d'une valeur de résistance inférieure, réduit le niveau de tension du premier dispositif de pile à combustible (7), le niveau de tension du second dispositif de pile à combustible (8) et/ou le niveau de tension de la batterie (20).
